# EUROPEAN PATENT SPECIFICATION

(11) **EP 2 736 071 B1**
(45) Date of publication and mention of the grant of the patent: **18.01.2017**
(21) Application number: 12290407.1
(22) Date of filing: 22.11.2012
(51) Int. Cl.: H01L 23/10, H01L 23/26, B81B 7/00, H01L 23/057, H01L 23/00

(54) **Wafer level package with getter**
Verkapselung mit Getter auf Waferebene
Emballage de niveau de tranche avec un dégazeur

(43) Date of publication of application: 28.05.2014
(73) Proprietor: Tronics Microsystems S.A., 38920 Crolles (FR)
(72) Inventor: Gigan, Olivier, 38000 Grenoble (FR); Gaff, Vincent, 38320 Brie (FR)
(74) Representative: Cabinet Laurent & Charras

(56) References cited:
- EP-A1- 2 141 117
- EP-A1- 2 451 740
- EP-A2- 1 296 385
- WO-A1-2005/107334
- WO-A1-2006/067784
- WO-A1-2012/072792
- US-A1- 2012 024 722
- US-B1- 6 252 294

## Description

### Technical Field

The invention relates to a wafer level package with a getter material and to a device comprising a sealed housing with a housing space and a wafer level package. Furthermore the invention relates to a method for manufacturing the wafer level package.

### Background Art

Micromachined electromechanical devices have been proposed in a great variety. A wide spread function of such devices is the detection of rotation (gyroscope) or linear acceleration. It is important that the mobile parts of such devices are within a sealed housing so that a vacuum or a particular gas filling can be maintained. Examples for mobile parts in a sealed space are shown in US 2008/0029863 (Honeywell), US 6,923,625 B1 (Integrated Sensing Systems Inc.), US 5,921,461 (Raytheon Company), WO 2010/112676 A1 (Valtion Teknillinen Tutkimuskeskus), EP 2 514 713 A1 (Tronics).

There are other devices that are arranged in sealed spaces, for instance semiconductor circuits and memories (US 4,630,095, VLSI Technology Research), phased-array antenna systems (US 2005/01621753 A1, Corp. for National Research Initiatives) and others.

US 4,630,095 (VSLI) discloses the well known technology used for memory chips, namely providing a getter at the inside of a wafer-level package. US 6,923,625 B1 (ISSIS) describes the getter at the inside of a wafer level package for a MEMS device. Integrated getters are also known from EP 1 412 550 B1 (Saes Getters S.p.A.).

Document EP 2 141 117 A1 (fig 1 E) and document EP 2 451 740 B1 (fig. 7) disclose two self-supporting element forming a hollow inside space and a getter material provided on the outside.

A wafer level package is generally speaking advantageous because it can be implemented during the manufacturing process of whole wafer. However, the prior art is still not fully satisfactory since the flexibility of the known solutions is limited. The process has to be specifically adapted to the particular type of device.

### Summary of the invention

It is the object of the invention to provide a wafer level package and a microelectronic device that are suitable to maintain a vacuum or a particular gas filling during the lifetime of the device. It is another object of the invention that the technical concept can be used for many different types of devices. Furthermore, the technical concept should be such that it can be implemented in the framework of processing steps that are needed for generating the microelectronic or micromechanical structure.

The solution of the invention is specified by the features of claim 1. According to the invention a wafer level package comprises:
a) at least two self-supporting elements connected to each other for forming a hollow inside space,
b) an opening connecting the hollow inside space to an outside surface of the at least two elements,
c) a getter material provided at an outside main face of the at least two of the self-supporting elements.

It is an important advantage of this invention that the manufacturing cost of the device are reduced by replacing an individual getter fixation on package cover by a collective getter deposition on the MEMS cap or base.

The self-supporting elements may be plates or chips made of silicon, ceramic, glass or other materials. The elements may also consist of several layers that are rigidly associated with each other or bonded together (e.g. a Silicon on Insulator structure = SOI). The elements are meant to have a sufficient thickness so that they can be individually handled during the manufacturing process. A layer that is provided on a substrate and that cannot be handled separately from the substrate is not a self-supporting element.

The elements are connected together e.g. be a fusing or bonding process such as a eutectic bonding (= eutectic soldering) process, an anodic bonding process or a polymeric sealing process.

When the two elements are connected they form a hollow inside space. There are different ways for providing the inside space. One option is that one of the two elements provides a hollow and the other is flat so that the inside space is defined by the hollow space in one of the two elements. Another option is to have a hollow in each of the two elements so that the inside space is formed by the combination of the two hollows. The hollows in the two elements may have different depth or size. The hollow inside space is sufficiently large for housing the microelektronic or micromechanical structure such as for instance the mobile MEMS structure of the semiconductor device.

The inside space is connected via an opening to the outside surface of at least one of the self-supporting elements. The opening may be a small hole that penetrates the element in a direction orthogonal to the main face of the plate-like element. The opening may also be a transit at the interface of the two connected elements. The opening is large enough that gas molecules can leave the inside space through the opening.

On the outer surface of the package there is a getter material attracting gas molecules that come out from the inside space and from the housing encapsulating the package. Getter materials are known in the art. They may comprise Zr, Ti, Nb, Ta, V, alloys of these metals and alloys further containing Cf, Mn, Fe, Co, Ni, AL, Y, LA and Rare Earths (see e.g. WO 2004/065289).

A wafer level package according to the invention may have a first of the at least two self-supporting elements which is a cap element and a second of the at least two self-supporting elements which is a base element, wherein the base element comprises a microelectronic or micromechanical structure. The micromechanical structure may be a mobile element of a MEMS sensor or of a control element (e.g. a mobile reflector for modulating an electromagnetic beam) of or an integrated circuit on a semiconductor substrate or the like. In a preferred embodiment the wafer level package is made of only two self-supporting elements. However, the invention is also applicable to stacks of elements (see e.g. US 2005/0161753 A1, WO 2010/112676 A1).

Place of getter material:
In a first specific embodiment of the invention the getter material is attached to the outer main face of the cap element. The getter material may be deposited by vapor deposition methods, or may be attached by gluing, soldering, clamping or equivalent. Since cap elements do usually not comprise complex structures, it is easier to implement the attachment of the getter material on said element.

In a second specific embodiment the getter material is provided at an outside main face of the base element.

According to a preferred embodiment the getter material is arranged in the form of a layer covering a predominant part of the said outer main surface. The layer may be deposited on top of the semiconductor surface of the cap element so that it is directly accessible. It is also possible, first to provide a buried getter layer and then to uncover certain parts of the layer that is covering the buried getter layer.

A specific embodiment of the invention is characterized in that the opening is provided in the cap element. This is typically more space saving than providing the opening in the base element which comprises the functional structure such as the integrated circuit, the MEMS structure, the antenna array etc. The getter layer may be on the main surface to which the opening discharges. However, it is also possible to have the opening discharge at an other place, e.g. at the main surface opposite to the main face of the getter layer.

The invention is preferably applied to MEMS devices. The mobile structure may be implemented in a continuous layer that is arranged at the inner surface of the base element. The MEMS structure may be implemented in a SOI substrate.

Sensor device:
The wafer level package of the invention is meant to be placed in a sealed housing. The housing space, in which the wafer level package is placed, is connected to the inner space of the wafer level package via the opening. The getter material, which is on the outside surface of the wafer level package, is therefore able to maintain the vacuum or the required partial pressure inside the wafer level package. The device may be a sensor device (gyroscope, accelerometer) or perform any other function (memory, processor, optical device etc.).

The housing comprises a base part and a cap part. The wafer level package is preferably attached (e.g. by glueing damping) to the base of the housing. There are other ways to fix the wafer level package inside the housing.

Manufacturing of wafer level package:
According to the invention a method for manufacturing a wafer level package comprises the steps of:
   a) providing at least two self-supporting elements, each of said elements having an inner and an outer surface, wherein at least one of said elements has an inner surface with at least one hollow and at least one of said elements has an opening,
   b) providing a getter material at the outside main surface of at least one of the self-supporting elements,
   c) connecting the two elements with the inner surfaces face to face so that at least one wafer level package with at least one hollow inside space is realized and that the opening connects the hollow inside space to the outside surface of one of the at least two elements and that the getter material is at the outside of the wafer level package.

The getter material is typically provided by deposition of a layer of NEG (non-evaporable getter) in a manner known in the art (WO 2004/065289 A2, Saes Getters SpA; US 6,923,625, Integrated Sensing Systems Inc. etc.) on the main face of the cap or base element.

When preparing the wafer level package it is advantageous to provide a wafer with a large array of hollows (e.g. one hollow per package). The same wafer may be provided with a corresponding plurality of openings (or through holes) penetrating the wafer from the inner face to the outer main face (The openings may alternatively be provided in the base element of the wafer level package). Then the two wafers are connected in such a way that each hollow can communicate to the outside via the opening. The connection process may include glass frit bonding or bonding with inter metallic layer or the like. The continuous array of wafer level packages may now be cut into individual packages. Each wafer level package may comprise one hollow and one opening.

Next, each wafer level package is introduced into a housing. The housing may consist of a base element and a cap element. The wafer level package may be attached e.g. to the base element. After that, the cap element is sealed to the base element, so that the housing space is isolated from the exterior atmosphere. The housing may be made of plastics, silicon, glass, metal etc. depending on the requirements of the planned use of the device.

The getter is activated shortly before or after closing the housing. If the activation takes place before the cap element of the housing is sealed to the base element of the housing, the activation step is executed under vacuum control or under required gas environment (i.e. under similar environmental conditions as the closing operation of the housing takes place). The activation can be a thermal or an electrical process.

The manufacturing method of the invention is preferably used for MEMS devices.

Other advantageous embodiments and combinations of features emerge from the detailed description below and the totality of the claims.

### Brief description of the drawings

The drawings used to explain the embodiments show:
- Fig. 1a - h: method for manufacturing a MEMS device;
- Fig. 2a - f: another method for manufacturing a MEMS device;
- Fig. 3a, b: schematic diagram of two different embodiments,
- Fig. 4a, b: schematic diagram of an embodiment with a passage at the interface of the base and cap element.

In the figures, same reference symbols are used for same components.

### Preferred embodiments

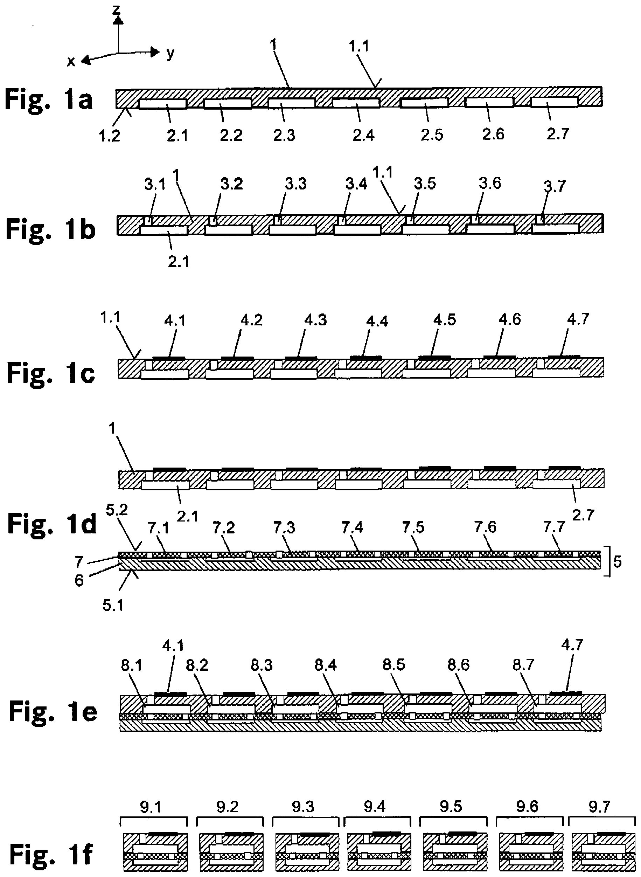

Fig. 1a - 1h illustrate the steps for manufacturing a MEMS device according to the invention.

Fig. 1a shows a cross section of a first wafer 1 having an outer main surface 1.1 and an inner main surface 1.2. The wafer 1 is relatively thin and defines a substrate plane (x-y) parallel to the outer and inner main surfaces 1.1, 1.2.

The outer main surface 1.1 is substantially flat but the inner main surface 1.2 is provided with a plurality of hollows 2.1, ..., 2.7. The hollows 2.1, ..., 2.7 are recesses or cavities that are etched into the inner main surface 1.2 for housing the mobile structure of the device. The thickness of the wafer 1 may be in the range of 0.2 - 0.5 mm and the stability is enough for handling the wafer 1 in a manner known in the art of wafer processing. That is, the wafer 1 is a self-supporting element.

Fig. 1b shows the step of machining holes into the wafer 1. According to the present example there is one hole 3.1, ..., 3.7 for each hollow 2.1, ..., 2.7. Each hole 3.1, ..., 3.7 may have a minimum diameter of 10 micrometer for ensuring a sufficient gas evacuation. One end of the hole 3.1, ..., 3.7 opens at the corresponding hollow 2.1, ..., 2.7 and the other end of the hole opens at the outer main surface 1.1. Therefore, the holes 3.1, ..., 3.7 provide a transit from the hollow of the inner surface of the wafer 1 to its outer surface.

Fig. 1c shows the step of attaching getter material on the outer main surface 1.1. In the present embodiment, there are separate (discontinuous) getter layers 4.1, ..., 4.7 associated with each hollow 2.1, ..., 2.7. The dimension of the separate getter layers in the plane of the outer main surface 1.1 may be about the same as the extension of the hollow 2.1,..., 2.7. The getter material may be deposited in a manner known in the art. The getter layers 4.1, ..., 4.7 may be covered with a protection layer (not shown) so that the getter can be activated (e.g. by local heating) when the device is finished. In the example of Fig. 1c the holes 3.1, ..., 3.7 are at the border of the hollows 2.1, ..., 2.7 and the individual getter layers are placed beneath the respective opening of the holes 3.1,..., 3.7.

Fig. 1d shows in the upper part the wafer 1, which forms a cap element (explained in Figs. 1a - 1c), and in the lower part a base element 5. The base element 5 has about the same shape and size in the substrate plane as wafer 1. In the present embodiment the base element 5 substantially consists of a wafer 6 that carries on its upper surface a MEMS layer 7. The MEMS layer 7 may be implemented e.g. by SOI technology and forms the inner main surface 5.2 of the base element 5. The outer main surface 5.1 is formed by the lower surface of the wafer 6.

Within the MEMS layer 7 there is a plurality of mobile structures 7.1,..., 7.7, which may be implemented in a manner known in the art. The mobile structures 7.1, ..., 7.7 may be designed to detect acceleration or rotation of the device.

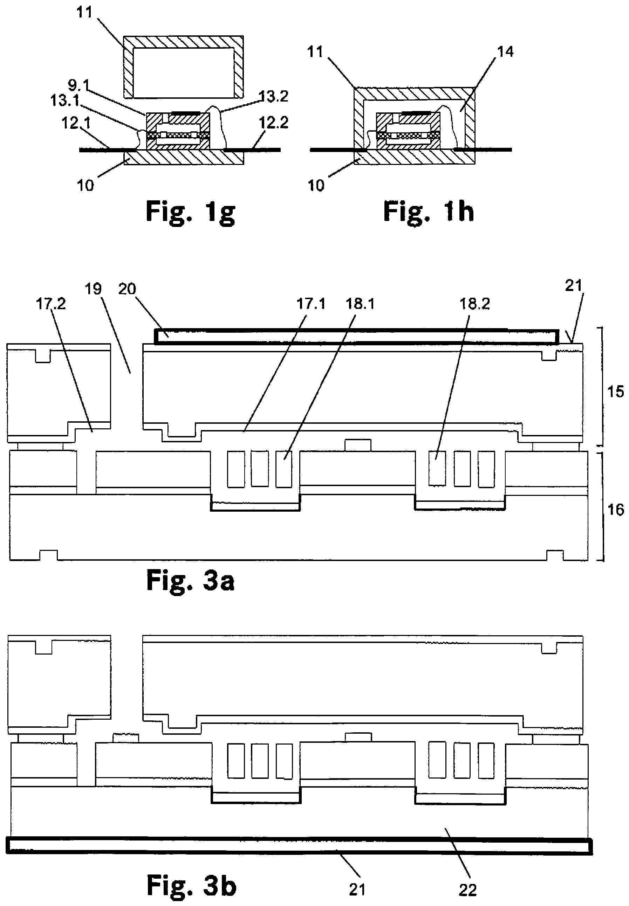

As shown in Fig. 1d, the hollows 2.1, ..., 2.7 match the base element 5 so that each of them provides a housing for one of the mobile structures 7.1, ..., 7.7, when the wafer 1 is attached and sealed to the base element 5 as shown in Fig. 1 e. In the present embodiment there is a plurality of cavities 8.1, ..., 8.7 inside the connected pair of base and cap element. Each cavity 8.1, ..., 8.7 may comprise a hollow 2.1, ..., 2.7 in the cap element and a hollow in the base element (e.g. a hollow below the MEMS layer). The cavities 8.1, ..., 8.7 are open to the outside via holes 3.1, ..., 3.7. The getter layers 4.1, ..., 4.7 are outside the cavities 8.1, ..., 8.7.

Fig. 1f shows the step of cutting the multi-cavity wafer level package of Fig. 1e into a plurality of single sensor elements 9.1, ..., 9.7, each having an individual wafer level package.

Fig. 1g shows the step of placing a sensor element 9.1 on a housing base 10 and fixing it (e.g. by gluing or any other process soldering). The housing base 10 may be a plate of ceramics, glass, plastics or some other appropriate housing material. It is important that the housing material is gas-tight.

The housing base 10 may be provided with a plurality of appropriate leads 12.1, 12.2 for electrically contacting the sensor element 9.1. In addition, said leads may be provided for contacting the getter activation electrodes, if the getter is activated by electrical energy. from the outside. These wiring 13.1, 13.2 between the contacts of the sensor element 9.1 and the leads 12.1, 12.2 are made in a manner known in the art.

Finally the housing cap 11 is attached to the housing base 10 in a gas tight manner. Prior to closing the housing, the housing space may be flooded by an inert gas or may be evacuated to a desired low pressure. After the sealing step, the housing space 14, which is provided for the sensor element 9.1, is isolated from the surrounding atmosphere. Now, the getter material can be activated and any undesired gas inside the sensor element cavity 8.1 is attracted by the getter material outside the wafer level package.

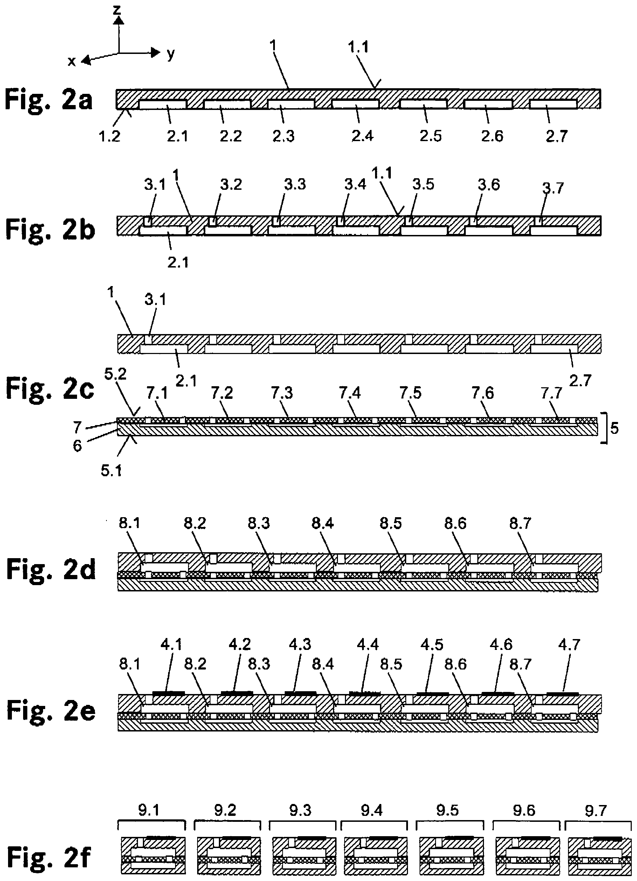

Fig. 2a - 2f illustrate another method for manufacturing the MEMS devices. The steps shown in Fig. 2a and 2b are the same as in the first embodiment (Fig. 1a, 1b). In contrast to the first embodiment (Fig. 1c), the getter is not attached to the cap wafer 1 prior to attaching and sealing the cap wafer 1 to the base element 5. Therefore, the cap element is combined with the base element 5 in the step shown in Fig. 2c (equivalent to Fig. 1d). So in Fig. 2d the cap element and the base element are connected to each other while there is still no getter on the cap element. Only in the next step (Fig. 2e) the getter is attached to the cap element. This may be achieved in a similar way as explained in connection with Fig. 1c. After that, the wafer package is cut into pieces (Fig. 2f) and the individual sensor elements 9.1, ..., 9. 7 may be processed as shown in Fig. 1g and 1h.

Fig. 3a shows a further embodiment of a wafer level package according to the invention. The cap element 15 of the sensor element has two hollows 17.1, 17.2. The first hollow 17.1 provides space for the (e.g. two) mobile MEMS structures 18.1, 18.2 provided on the base element 16 and the other hollow 17.2, which is in gas communication with the first hollow 17.1, is in gas communication with the outside surface of the wafer level package via the passage 19. The getter material 20 is a layer on the outer main surface 15.1 of the cap element 15.

Fig. 3b differs from Fig. 3a in that the getter material 21 is a layer fully covering the outer main surface of the base element 22.

The passage may alternatively be provided in the base element. It is also within the scope of the invention that passages are provided in both elements, namely in the cap element and in the base element. The passages are preferably straight channels that penetrate the cap or base element orthogonal with respect to the substrate plane.

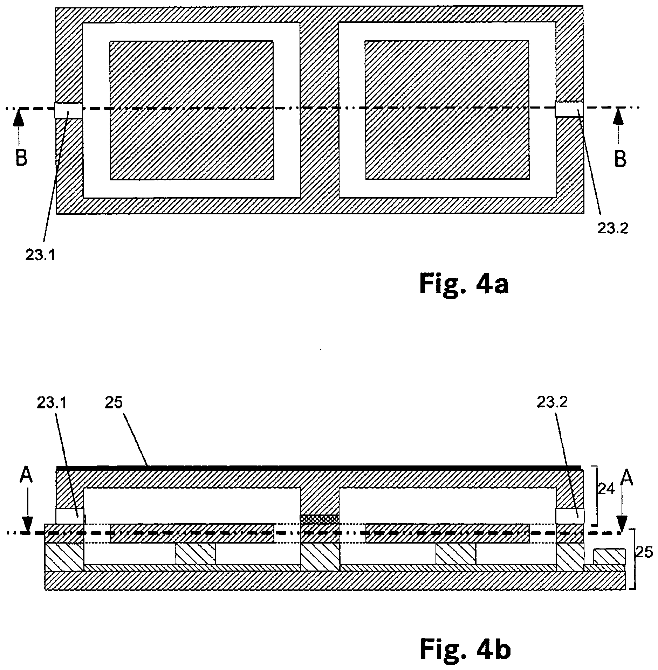

Fig. 4a, 4b show an embodiment in which the passages 23.1, 23.2 are at the interface of the cap element 24 and the base element 25. The passages 23.1, 23.2 may be channel-like recesses running parallel to the substrate plane in the border area of the cap element 24. The getter material 26 may be a layer fully covering tho outer main surface of the cap element 24.

The invention is not limited to the above mentioned embodiments. There are many modifications that can easily be derived from the description and claims.

For instance, there may be more than two mobile structures that are in one common hollow. Also, more than two mobile structures may be in separate cavities. There might be hollows without a mobile structure. A single waver level package of a sensor device may have more than one passage in order to optimize gas extraction.

The invention does not exclude that there is additional getter material in the cavity of the wafer level package. However, it is preferred that there is no getter material within the cavity of the package.

While it is preferred that the cap element and the base element (see reference numeral 1 and 5 in Fig. 1 and 2) of the wafer level package are sealed to each other in a gas tight manner, this is not necessary for the purpose of the invention. It is sufficient that the two elements 1 and 5 are rigidly connected to each other.

In summary, it is to be noted that the invention provides a wide field of applications because the manner in which the gas within the wafer level package is caught is not dependent on the particular manufacturing process of the functional element (mobile elements, semiconductor circuit etc.) that is in the wafer level package.

## Claims

1. A wafer level package comprising:
a) at least two self-supporting elements (1,5) connected to each other for forming a hollow inside space (8.1,..., 8.7),
b) an opening (3.1, ..., 3.7) connecting the hollow inside space to an outside surface of the at least two elements (1, 5),
c) a getter material (4.1, ..., 4.7) provided at an outside main face (1.1) of the at least two of the self-supporting elements (1, 5).

2. A wafer level package according to claim 1, **characterized in that** a first (1) of the at least two self-supporting elements (1, 5) is a cap element and a second (5) of the at least two self-supporting elements is a base element, wherein the base element comprises a microelectronic structure (7.1, ..., 7.7).

3. A wafer level package according to claim 1 or 2, **characterized in that** the getter material (4.1, ..., 4.7) is provided at the outer main surface of the cap element.

4. A wafer level package according to any of claims 1 to 3, **characterized in that** the getter material (21) is provided at the outer main surface of the base element (22).

5. A wafer level package according to claim 3 or 4, **characterized in that** the getter material (20) is arranged in the form of a layer covering a predominant part of the said outer surface (21).

6. A wafer level package according to any of claims 2 to 5, **characterized in that** the opening (3.1, ..., 3.7) is provided in the cap element (1).

7. A wafer level package according to any of claims 2 to 6, **characterized in that** the base element (5) comprises a mobile structure (7.1,..., 7.7) of a MEMS device.

8. A device comprising a sealed housing (10, 11) with a housing space (14) and a wafer level package (9.1) according to any of claims 1 to 7 arranged in said housing space (14).

9. A device according to claim 8, **characterized in that** housing comprises a housing base (10) and a housing cap (11) and that the wafer level package is attached to the housing base (10).

10. Method for manufacturing a wafer level package comprising the steps of:
a) providing at least two self-supporting elements, each of said elements having an inner and an outer surface, wherein at least one of said elements having in inner surface with at least one hollow and at least one of said elements having an opening,
b) providing a getter material to the outside of at least one of the self-supporting elements,
c) connecting the two elements with the inner surfaces face to face so that at least one wafer level package with at least one hollow inside space is realized and the opening connects the hollow inside space to the outside surface of one of the at least two elements and the getter material is at the outside of the wafer level package.

11. Method according to claim 10, **characterized in that** the self-supporting elements have a plurality of hollows and a corresponding plurality of openings.

12. Method according to claim 11, **characterized in that** after connecting the two elements the connected elements are cut into a plurality of separate units each unit having an area of the getter material.

13. Method according to any of claims 10 to 12, **characterized in that** a first of the at least two self-supporting elements is a cap element and a second of the at least two self-supporting elements is a base element, wherein the base element comprises a micromachined mobile structure.

14. Method for manufacturing a sensor device applying the method for manufacturing a wafer level package according to claim 10, **characterized in that** the wafer level package is placed in a sealed housing.

## Patentansprüche

1. Verkapselung auf Waferebene bestehend aus:
a) mindestens zwei selbsttragenden Elemente (1, 5), die so miteinander verbunden sind, dass sie einen hohlen Innenraum bilden, (8.1, ..., 8.7),
b) einer Öffnung (3.1, ..., 3.7), die den hohlen Innenraum mit einer Außenfläche der mindestens zwei Elemente (1, 5) verbindet,
c) ein Getter- Material (4.1, ..., 4.7), vorgesehen an einer äußeren Hauptfläche (1,1) der mindestens zwei der selbsttragenden Elemente (1, 5).

2. Verkapselung auf Waferebene gemäß Anspruch 1, **dadurch gekennzeichnet, dass** ein erstes (1) der mindestens zwei selbsttragenden Elemente (1, 5) ein Deckelelement ist und dass ein zweites der mindestens zwei selbsttragenden Elemente (5) ein Basiselement ist, wobei das Basiselement eine mikroelektronische Struktur umfasst (7.1, ......, 7.7).

3. Verkapselung auf Waferebene gemäß Anspruch 1 oder 2, **dadurch gekennzeichnet, dass** das Getter - Material (4.1, ...., 4.7) auf der äußeren Hauptfläche des Deckelelementes vorgesehen ist.

4. Verkapselung auf Waferebene gemäß einem der Ansprüche 1 bis 3, **dadurch gekennzeichnet, dass** das Getter - Material (21) auf der äußeren Hauptfläche des Basiselementes (22) vorgesehen ist.

5. Verkapselung auf Waferebene gemäß Anspruch 3 oder 4, **dadurch gekennzeichnet, dass** das Getter - Material (20) in Form einer Schicht angeordnet ist, die einen überwiegenden Teil dieser äußeren Hauptfläche (21) bedeckt.

6. Verkapselung auf Waferebene gemäß Anspruch 2 bis 5, **dadurch gekennzeichnet, dass** die Öffnung (3.1, ...... 3.7) im Deckelelement (1) vorgesehen ist.

7. Verkapselung auf Waferebene gemäß einem der Ansprüche 2 bis 6, **dadurch gekennzeichnet, dass** das Basiselement (5) eine mobile Struktur (7.1, .... 7.7) einer MEMS- Vorrichtung enthält.

8. Vorrichtung, umfassend ein abgedichtetes Gehäuse (10, 11) mit einem Gehäuseraum (14) und einer Verkapselung auf Waferebene (9.1) gemäß einem der Ansprüche 1 bis 7, angeordnet in diesem Gehäuseraum (14).

9. Eine Vorrichtung, gemäß Anspruch 8, **dadurch gekennzeichnet, dass** das Gehäuse eine Gehäusebasis (10) und einen Gehäusedeckel (11) umfasst und dass die Verkapselung auf Waferebene mit der Gehäusebasis (10) verbunden ist.

10. Verfahren zur Herstellung einer Verkapselung auf Waferebene, das die folgenden Schritte umfasst:
a) Bereitstellung von mindestens zwei selbsttragenden Elementen, jedes dieser Elemente weist eine Innen- und eine Außenfläche auf, wobei mindestens eines dieser Elemente eine Innenfläche mit mindestens einen Hohlraum hat und mindestens eines dieser Elemente eine Öffnung hat,
b) Aufbringen eines Getter- Materials auf der Außenseite von mindestens einem dieser selbsttragenden Elemente,
c) Verbindung dieser beiden Elemente wobei die Innenflächen gegenüberstehen, so dass mindestens eine Verkapselung auf Waferebene mit mindestens einem hohlen Innenraum ausgeführt wird und die Öffnung den hohlen Innenraum, mit der Außenfläche von einem der mindestens zwei Elemente verbindet und sich das Gettermaterial auf der Außenseite der Verkapselung auf Waferebene befindet.

11. Verfahren gemäß Anspruch 10, **dadurch gekennzeichnet, dass** die selbsttragenden Elemente eine Vielzahl von Hohlräumen und eine entsprechende Anzahl Öffnungen aufweisen.

12. Verfahren gemäß Anspruch 11, **dadurch gekennzeichnet, dass** nach Verbindung der beiden Elemente die verbundenen Elemente in eine Vielzahl von getrennten Einheiten geteilt werden, wobei jede einzelne Einheit einen Bereich mit Getter - Material hat.

13. Verfahren gemäß einem der Ansprüche 10 bis 12, **dadurch gekennzeichnet, dass** ein erstes der mindestens zwei selbsttragenden Elemente ein Deckelelement ist und ein zweites der mindestens zweit selbsttragenden Elemente ein Basiselement ist, wobei das Basiselement eine mikrotechnisch hergestellte, bewegliche Struktur umfasst.

14. Verfahren zur Herstellung einer Sensorvorrichtung, unter Anwendung des Verfahrens zur Herstellung einer Verkapselung auf Waferebene gemäß Anspruch 10, **dadurch gekennzeichnet, dass** die Verkapselung auf Waferebene in einem abgedichteten Gehäuse untergebracht ist.

## Revendications

1. Emballage de niveau de tranche comprenant :
a) au moins deux éléments autoporteurs (1, 5) connectés l'un à l'autre pour former un espace intérieur creux (8.1, ..., 8.7),
b) une ouverture (3.1, ..., 3.7) connectant l'espace intérieur creux à une surface extérieure des au moins deux éléments (1, 5),
c) un matériau dégazeur (4.1, ..., 4.7) situé au niveau d'une face principale extérieure (1.1) des au moins deux des éléments autoporteurs (1, 5).

2. Emballage de niveau de tranche selon la revendication 1, **caractérisé en ce qu'**un premier (1) des au moins deux éléments autoporteurs (1, 5) est un élément de couvercle et un second (5) des au moins deux éléments autoporteurs est un élément de base, dans lequel l'élément de base comprend une structure microélectronique (7.1, ..., 7.7).

3. Emballage de niveau de tranche selon la revendication 1 ou 2, **caractérisé en ce que** le matériau dégazeur (4.1, ..., 4.7) se situe au niveau de la surface principale extérieure de l'élément de couvercle.

4. Emballage de niveau de tranche selon l'une quelconque des revendications 1 à 3, **caractérisé en ce que** le matériau dégazeur (21) se situe au niveau de la surface principale extérieure de l'élément de base (22).

5. Emballage de niveau de tranche selon la revendication 3 ou 4, **caractérisé en ce que** le matériau dégazeur (20) est agencé sous la forme d'une couche recouvrant une partie prédominante de ladite surface extérieure (21).

6. Emballage de niveau de tranche selon l'une quelconque des revendications 2 à 5, **caractérisé en ce que** l'ouverture (3.1, ..., 3.7) se situe dans l'élément de couvercle (1).

7. Emballage de niveau de tranche selon l'une quelconque des revendications 2 à 6, **caractérisé en ce que** l'élément de base (5) comprend une structure mobile (7.1, ..., 7.7) d'un dispositif MEMS.

8. Dispositif comprenant un boîtier scellé (10, 11) doté d'un espace (14) de boîtier et d'un emballage de niveau de tranche (9.1) selon l'une quelconque des revendications 1 à 7 agencé dans ledit espace (14) de boîtier.

9. Dispositif selon la revendication 8, **caractérisé en ce que** le boîtier comprend une base (10) de boîtier et un couvercle (11) de boîtier et **en ce que** l'emballage de niveau de tranche est attaché à la base (10) de boîtier.

10. Procédé de fabrication d'un emballage de niveau de tranche comprenant les étapes consistant à :
a) fournir au moins deux éléments autoporteurs, chacun desdits éléments ayant une surface intérieure et une surface extérieure, dans lequel au moins un desdits éléments a une surface intérieure avec au moins un creux et au moins un desdits éléments a une ouverture,
b) fournir un matériau dégazeur à l'extérieur d'au moins un des éléments autoporteurs,
c) connecter les deux éléments avec les surfaces intérieures face à face de telle sorte qu'au moins un emballage de niveau de tranche avec au moins un espace intérieur creux est réalisé et l'ouverture connecte l'espace intérieur creux à la surface extérieure de l'un des au moins deux éléments et le matériau dégazeur se trouve à l'extérieur de l'emballage de niveau de tranche.

11. Procédé selon la revendication 10, **caractérisé en ce que** les éléments autoporteurs comportent une pluralité de creux et une pluralité correspondante d'ouvertures.

12. Procédé selon la revendication 11, **caractérisé en ce que**, après la connexion des deux éléments, les éléments connectés sont découpés en une pluralité d'unités séparées, chaque unité ayant une zone du matériau dégazeur.

13. Procédé selon l'une quelconque des revendications 10 à 12, **caractérisé en ce qu'**un premier des au moins deux éléments autoporteurs est un élément de couvercle et un second des au moins deux éléments autoporteurs est un élément de base, dans lequel l'élément de base comprend une structure mobile micro-usinée.

14. Procédé de fabrication d'un dispositif capteur appliquant le procédé pour fabriquer un emballage de niveau de tranche selon la revendication 10, **caractérisé en ce que** l'emballage de niveau de tranche est placé dans un boîtier scellé.
